# EUROPÄISCHE PATENTANMELDUNG

(11) **EP 1 394 843 A2**
(43) Veröffentlichungstag der Anmeldung: **03.03.2004**
(21) Anmeldenummer: 03019397.3
(22) Anmeldetag: 27.08.2003
(51) Int. Cl.: H01L 21/311, H01L 21/66

(54) **Barriereschicht und Verfahren zur Unterdrückung von Diffusionsvorgängen bei der Herstellung von Halbleitereinrichtungen**

(30) Priorität: 30.08.2002 DE 10240106
(71) Anmelder: Infineon Technologies AG, 81669 München (DE)
(72) Erfinder: Hecht, Thomas, 01099 Dresden (DE); Schroeder, Uwe, 01109 Dresden (DE); Seidl, Harald, 85622 Feldkirchen (DE); Gutsche, Martin, 84405 Dorfen (DE); Jakschik, Stefan, 01309 Dresden (DE); Kudelka, Stefan, 01458 Ottendorf-Okrilla (DE); Birner, Albert, 01129 Dresden (DE)
(74) Vertreter: Müller - Hoffmann & Partner

(57) **Zusammenfassung**

Eine dielektrische Barriereschicht (2) aus einem Metalloxid, wird im Zuge einer Prozessierung von Halbleitereinrichtungen mittels sequentieller Gasphasenabscheidung oder Molekularstrahlepitaxie in molekularen Einzellagen auf unterschiedlich strukturierten Grundsubstraten (1) in geringen Schichtdicken von kleiner 20 Nanometern aufgebracht. Das Verfahren ermöglicht u.a. quasi leitende Diffusionsbarrieren aus dielektrischem Material, eine Optimierung der Schichtdicke der Barriereschicht (2), eine Erhöhung des Temperaturbudgets für nachfolgende Prozessschritte und eine Verringerung des Aufwands für das Entfernen temporärer Barriereschichten (2).

## Beschreibung

Die Erfindung betrifft ein Verfahren zur Vermeidung von Verunreinigungen von Schichten und Strukturen in einem Halbleiterwafer durch Fremdstoffe im Zuge einer Fertigung von Halbleitereinrichtungen, bei dem ein mindestens abschnittsweise aus einem Primärmaterial ausgebildetes Grundsubstrat bereitgestellt, mindestens auf den vom Primärmaterial gebildeten Abschnitten einer Substratoberfläche des Grundsubstrats eine Barriereschicht aus einem für einen oder mehrere Fremdstoffe im Wesentlichen undurchdringlichen Barrierenmaterial vorgesehen und das mit der Barriereschicht versehene Substrat einer weiteren Prozessierung unterzogen wird, wobei durch die Barriereschicht ein Austreten/Eindringen des oder der Fremdstoffe aus dem/in das Primärmaterial verhindert wird.

Mit der stetigen Verkleinerung der Strukturgrößen in Halbleitereinrichtungen und mit der Erweiterung des Spektrums verwendeter Materialien gewinnen in der Halbleiterprozesstechnologie zunehmend Barriereschichten an Bedeutung, die den Übergang von Fremdstoffen zwischen zwei Schichten oder Strukturen bzw. zwischen einer Schicht oder Struktur und einer Umgebungsatmosphäre weitgehend verhindern.

Der eindringende Fremdstoff kann dabei chemisch aktiv sein und ein Material der betroffenen Schicht bzw. Struktur oxidieren oder reduzieren, etwa O₂, H₂, NO, N₂O und NH₃. Quellen oxidierender oder reduzierender Stoffe sind sowohl Feststoffe als auch eine Prozess- oder Umgebungsatmosphäre.

Durch ein Eindiffundieren chemisch weitgehend inaktiver Fremdstoffe in Form einzelner Atome wird die betroffene Schicht bzw. Struktur verunreinigt. Verunreinigungen führen zu Fehlstellen in Kristallgittern und verändern die elektrischen, chemischen und physikalischen Eigenschaften der betroffenen Struktur in zumeist nachteiliger Weise.

Quelle von Fremdatomen sind an die betroffenen Schichten bzw. Strukturen angrenzende Strukturen und Schichten oder eine mit den Fremdatomen verunreinigte Umgebung. Barriereschichten werden daher auch vorgesehen, um ein Ausdiffundieren von Stoffen in eine Umgebungs- oder Prozessatmosphäre zu verhindern.

Bei der Verwendung von Kupfer als Material für niederohmige Verbindungsleitungen sind als Barriereschichten ausgebildete Diffusionsbarrieren aus Übergangsmetallnitriden wie Titannitrid üblich, die ein Eindiffundieren von Kupfer in Halbleiter- strukturen und dielektrische Isolatorstrukturen blockieren.

Bekannte Konzepte für ferroelektrischen Speicherzellen von FeRAMs (ferroelectric random access memories) sehen Iridium- bzw. Rutheniumschichten als Sauerstoffbarriereschichten an einem Übergang zwischen einer Verbindungsstruktur zu einem Auswahltransistor der Speicherzelle und einer Platinelektrode einer ferroelektrischen Speichereinrichtung vor. Die Verbindungsstruktur besteht aus polykristallinem Silizium oder einem Metall, dessen Oxidation während eines Rekristallationsprozesses des ferroelektrischen Materials durch die Sauerstoffbarriereschicht vermieden wird. Wasserstoffbarriereschichten schützen das ferroelektrische Material vor einer Reduktion während einer Wasserstofftemperung, die an mehreren Stellen im Prozessfluss insbesondere gegen Ende der Prozessierung einer Halbleitereinrichtung üblich ist.

Siliziumnitridschichten verhindern eine Oxidation bzw. Reduktion von zu schützenden Schichten und Strukturen bei in oxidierender oder reduzierender Umgebung auszuführenden Temper- bzw. Annealschritten, etwa zur Rekristallisation von Prozessschichten.

Nachteilig an bisher bekannten Barriereschichten etwa von Siliziumnitridschichten ist deren begrenztes thermisches Budget. Nachteilig an durch chemische Niedrigdruck-Gasphasenabscheidung (low pressure chemical vapour deposition, LPCVD) abgeschiedenen Barriereschichten ist insbesondere die mit der Art der Abscheidung einhergehende ungleichmäßige Schichtdicke. Um eine durch die schwächste Stelle bestimmte Mindestfunktionalität zu gewährleisten, wird die Barriereschicht mit einer größeren durchschnittlichen Schichtdicke vorgesehen als es bei gleichmäßiger Bedeckung erforderlich wäre. Mit zunehmender Schichtdicke wird das Entfernen einer temporären Barriereschicht aufwändiger bzw. ein Störeffekt durch eine remanente Barriereschicht größer. Insbesondere auf strukturierten, dreidimensionalen Oberflächen sind herkömmlich vorgesehene Barriereschichten umständlich zu prozessieren.

Der Erfindung liegt daher die Aufgabe zugrunde, ein Verfahren zur Verfügung zu stellen, mit dem das Austreten und/oder das Eindringen von Fremdstoffen aus bzw. in Strukturen und Schichten unabhängig von einer Ausbildung der Struktur und einer Strukturierung der Schicht verhindert wird und bei dem nachteilige Nebeneffekte von auf herkömmliche Weise vorgesehenen Barriereschichten verringert werden. Ferner umfasst die Aufgabe der Erfindung eine Barriereschicht.

Diese Aufgabe wird bei einem Verfahren der eingangs genannten Art durch die im kennzeichnenden Teil des Patentanspruchs 1 angegebenen Merkmale gelöst. Eine die Aufgabe lösende Barriereschicht ergibt sich aus dem Patentanspruch 19. Vorteilhafte Weiterbildungen ergeben sich aus den jeweiligen Unteransprüchen.

Gemäß dem Verfahren zur Vermeidung von Verunreinigungen von Schichten und Strukturen in einem Halbleiterwafer durch Fremdstoffe im Zuge einer Fertigung von Halbleitereinrichtungen wird ein mindestens abschnittsweise aus einem Primärmaterial ausgebildetes Grundsubstrat bereitgestellt. Auf den vom Primärmaterial gebildeten Abschnitten einer Substratoberfläche des Grundsubstrats wird eine Barriereschicht aus einem für einen oder mehrere Fremdstoffe im Wesentlichen undurchdringlichen Barrierenmaterial vorgesehen. Das mit der Barriereschicht versehene Substrat wird einer weiteren Prozessierung unterzogen. Während dieser Prozessierung wird durch die Barriereschicht ein Austreten des oder der Fremdstoffe aus dem Primärmaterial und/oder ein Eindringen eines Fremdstoffs in das Primärmaterial verhindert.

Erfindungsgemäß wird dazu die Barriereschicht mittels sequentieller Gasphasenabscheidung (ALD, atomic layer deposition) oder Molekularstrahlepitaxie als dielektrische Schicht auf dem Grundsubstrat abgeschieden und dabei aus Siliziumnitrid, einem Metalloxid, etwa auch einem Oxid seltener Erden, vorgesehen.

Wird eine Barriereschicht als ein konformes Schichtsystem aus mehreren molekularen Einzellagen eines dielektrischen Materials, wie es sich bei der sequentiellen Gasphasenabscheidung ergibt, vorgesehen, so verbessern sich gegenüber herkömmlichen Barriereschichten bei vergleichbarer maximaler Schichtdicke deren Barriereeigenschaften stark. Insbesondere dann, wenn die Barriereschicht auf einer reliefartig strukturierten, dreidimensionalen Substratoberfläche aufgebracht wird, kann die Schichtdicke der Barriereschicht gegenüber herkömmlichen Verfahren deutlich reduziert werden, da auch mit geringen Schichtdicken von wenigen Nanometern eine gute Kantenbedeckung erzielt wird. Da die Barriereeigenschaften direkt mit der Schichtdicke zusammenhängen und da ferner die Schichtdicke beim erfindungsgemäßen Verfahren auf eine einzige molekulare Einzellage genau eingestellt werden kann, lässt sich die Schichtdicke der Barriereschicht in vorteilhafter Weise präzise an die Erfordernisse anpassen bzw. minimieren. Das Entfernen temporärer Barriereschichten wird dadurch wesentlich vereinfacht. Funktionale Störeffekte durch remanente Barriereschichten, etwa ein erhöhter ohmscher Widerstand quer zur Barriereschicht, werden reduziert. Die geringe Schichtdicke lässt es zudem zu, nur temporär erforderliche Barriereschichten, die, wären sie auf herkömmliche Weise vorgesehen, wieder entfernt werden müssten, zu belassen oder sie ohne zusätzlichen Ätzprozess zu entfernen.

Metalloxide wie etwa HfO₂, ZrO₂, Ta₂O₅, Nb₂O₅, Al₂O₃ einschließlich Oxiden seltener Erden wie Pr₂O₅ und La₂O₃ weisen durch ihre hohe Bildungsenthalpie ein hohes Temperaturbudget auf. Durch die im Zuge des erfindungsgemäßen Verfahrens erzeugten Barriereschichten wird die nachfolgende Prozessierung daher in vorteilhafter Weise variabler, da dieser dann ein höheres Temperaturbudget zur Verfügung steht.

Dielektrische Barriereschichten weisen fallweise bessere Hafteigenschaften bezüglich des unterliegenden Grundsubstrats bzw. bezüglich einer aufliegenden Prozessschicht auf.

Die dielektrische Barriereschichten können weiter dazu beitragen, bei Temper- bzw. Wärmeschritten bei hohen Prozesstemperaturen auftretende mechanische Spannungen zwischen den durch sie getrennten Schichten bzw. Strukturen zu reduzieren.

Das erfindungsgemäße Verfahren ermöglicht die Ausbildung von konformen Barriereschichten bzw. Grenzflächenschichten mit einer Schichtdicke, bei der auch Grenzflächenschichten und Barriereschichten aus dielektrischen Materialien infolge des Tunneleffekts als elektrisch leitfähig einzuordnen sind.

In besonders vorteilhafter Weise wird die Barriereschicht in einer Schichtdicke vorgesehen, bei der durch die Barriereschicht ein auf dem quantenmechanischen Tunneleffekt beruhenden Ladungsträgertransport in mehr als unerheblichem Umfang auftreten kann. Von einem Ladungsträgertransport in mehr als unerheblichem Umfang kann abhängig von der Anwendung und dem verwendeten Material bei Stromdichten größer etwa 10⁻⁵ A/cm² bis 10⁻⁴ A/cm² für Anwendungen mit Isolationscharakter und größer 10⁻² A/cm² für Anwendungen mit leitfähigem Charakter ausgegangen werden.

Die Barriereschichten werden fallweise nach dem Abscheiden einem Temper- bzw. Annealschritt unterzogen, im Zuge dessen etwa ein mittels der sequentiellen Gasphasenabscheidung zunächst amorph abgeschiedenes Aluminiumoxid zu Kristalliten unterschiedlicher Kristallstruktur verdichtet wird. Entlang der durch die Kristallite gebildeten Korngrenzen kann sich bei Schichtdicken von unter etwa 20 Nanometern etwa bei Aluminiumoxid als Barrierenmaterial ein Fehlstellen gestützes Tunneln (trapped assisted tunneling) von Ladungsträgern in nennenswertem Umfang ergeben. Wird die Barriereschicht in einer solchen Schichtdicke vorgesehen, so bleibt ein störender Einfluss einer remanenten Barriereschicht, etwa bezüglich eines elektrischen Widerstands zwischen einer ersten leitfähigen Struktur im Grundsubstrat und einer zweiten leitfähigen Struktur in einer auf der Barriereschicht vorgesehen Prozesschicht gering.

Bevorzugt wird die Barriereschicht in einer Schichtdicke kleiner 20 Nanometer abgeschieden. Temporäre Barriereschichten, wie etwa 5 Nanometer dicke Aluminiumoxidschichten, lassen sich bei sehr geringen Schichtdicken auf mechanischem Wege, etwa durch Teilchenbeschuss, auf einfache Weise quasi pulverisieren und entfernen.

Das Verfahren ist dann besonders vorteilhaft, wenn das bereitgestellte Grundsubstrat ein aus Gräben und Stegen gebildetes, dreidimensionales Relief an der Substratoberfläche aufweist. In diesem Fall kann wegen der guten Kantenbedeckung des Abscheideverfahrens die Schichtdicke der Barriereschicht gegenüber herkömmlichen Verfahren besonders deutlich reduziert werden kann.

In einer ersten bevorzugten Ausführungsform des erfindungsgemäßen Verfahrens wird durch die erfindungsgemäß vorgesehene Barriereschicht ein Eindringen von oxidierenden oder reduzierenden Fremdstoffen in das der Barriereschicht unterliegende Primärmaterial verhindert.

Wird etwa im Zuge einer Fertigung einer ferroelektrischen Halbleitereinrichtung als Primärmaterial ein Perovskit wie etwa Strontium-Wismut-Tantalat SBT oder Blei-Zirkonium-Titanat PZT vorgesehen, so wird durch die Barriereschicht während einer Wasserstofftemperung des Grundsubstrats in vorteilhafter Weise eine Reduktion des Perovskits durch eindiffundierenden Wasserstoff verhindert.

Bei einem Wärmeschritt in ammoniakhaltiger Umgebung wird mittels der Barriereschicht eine Nitridierung des Primärmaterials, etwa Silizium, ein Metall oder ein Übergangsmetall verhindert.

Bei einem Wärmeschritt in arsinhaltiger Umgebung (AsH₃) wird durch die Barriereschicht (2) eine Dotierung des Primärmaterials mit Arsen verhindert.

In bevorzugter Weise wird die Barriereschicht (2) nach dem Wärme- oder Annealschritt in einem Hochtemperaturschritt aufgebrochen und dadurch die Leitfähigkeit der Barriereschicht erhöht. Ein störender Einfluss einer remanenten Barriereschicht wird dadurch in vorteilhafter Weise verringert.

Gemäß einer weiteren bevorzugten Ausführungsform des erfindungsgemäßen Verfahrens wird auf der Barriereschicht eine mindestens abschnittsweise aus einem Sekundärmaterial bestehende Prozessschicht vorgesehen. Die Barriereschicht verhindert dann eine Diffusion von Atomen des Primärmaterials als Fremdatome in das Sekundärmaterial und/oder umgekehrt.

Wird als Primärmaterial ein dielektrisches Material oder ein Halbleitermaterial und als Sekundärmaterial ein metallhaltiges Material oder als Primärmaterial das metallhaltige Material und als Sekundärmaterial das dielektrische Material oder das Halbleitermaterial vorgesehen, so wird durch die Barriereschicht primär eine Diffusion von Metallatomen und Metallionen aus dem metallhaltigen Material in das dielektrische Material bzw. das Halbleitermaterial unterdrückt.

Werden als Primärmaterial und als Sekundärmaterial jeweils Halbleitermaterialien vorgesehen, die sich in ihrer Dotierung unterscheiden, so wird durch die Barriereschicht eine Diffusion von Dotierstoffatomen vom Primär- in das Sekundärmaterial und/oder umgekehrt verhindert.

In vorteilhafter Weise wird als Primärmaterial einkristallines Silizium und als Sekundärmaterial polykristallines Silizium vorgesehen. Wird als Primärmaterial ein Halbleitermaterial mit einem einkristallinen Aufbau und für das zweite Material ein Halbleitermaterial mit einem polykristallinen Aufbau vorgesehen, so blockiert eine erfindungsgemäß als Grenzflächenschicht vorgesehene Barriereschicht auch das Wachsen von Versetzungen und Korngrenzen des polykristallinen Halbleitermaterials in das einkristalline Halbleitermaterial hinein.

Durch eine mittels des sequentiellen Gasphasenabscheidungsprozesses ausgebildete Barriereschicht aus Aluminiumoxid mit einer Schichtdicke von maximal 2 Nanometern bleibt nach im Zuge einer Prozessierung von Halbleitereinrichtungen üblichen Temperschritten ein Unterschied in der Dotierstoffkonzentration beiderseits der Barriereschicht in Höhe eines Faktors 5 aufrecht erhalten.

In einer besonders bevorzugten Ausführungsform des erfindungsgemäßen Verfahrens wird von der Substratoberfläche her ein Graben in ein Halbleitersubstrat als Grundsubstrat eingebracht. Ein Abschnitt des Grabens unterhalb einer Kragenoberkante wird mit einem Kragenisolator ausgekleidet. Ein erster Teilabschnitt einer Füllstruktur aus dem Sekundärmaterial wird unterhalb der Kragenoberkante vorgesehen. Die Grenzflächenschicht wird vorgesehen, wobei der Graben oberhalb der Kragenoberkante mindestens abschnittsweise mir der Grenzflächenschicht ausgekleidet wird. Ein zweiter Teilbereich der Füllstruktur wird oberhalb der Kragenoberkante angeordnet. In einem oberhalb der Kragenoberkante an den Graben anschließenden Abschnitt des Halbleitersubstrats wird eine leitfähige Struktur als ein erster Abschnitt des Halbleitersubstrats aus dem Primärmaterial ausgebildet.

Dabei wird das Ausbilden der Grenzflächenschicht selektiv auf den vertikalen Abschnitten der ersten Struktur durch die erweiterte Materialauswahl des erfindungsgemäßen Verfahrens ermöglicht bzw. stark vereinfacht.

Wird als Material der Grenzflächenschicht ein Material vorgesehen, dessen Ätzresistenz durch Ionenimplantation beeinflussbar ist, so umfasst das Ausbilden der Grenzflächenschicht selektiv auf vertikalen Abschnitten der ersten Struktur, bzw. auf Abschnitten der Grabenwandung oberhalb der Kragenkante des Grabens zunächst eine konforme Abscheidung einer Hilfsschicht aus dem Material der Grenzflächenschicht. Danach wird die Ätzresistenz von zur Substratoberfläche horizontalen Abschnitten der Hilfsschicht durch Ionenimplantation senkrecht zur Substratoberfläche selektiv gegen vertikale Abschnitte der Hilfsschicht verringert. Anschließend werden die horizontalen Abschnitte der Hilfsschicht selektiv gegen die vertikalen Abschnitte zurückgebildet. Die verbliebenen senkrechten Abschnitte der Hilfsschicht bilden die Grenzflächenschicht aus.

Ein für ein solches Verfahren geeignetes Material ist Aluminiumoxid Al₂O₃.

Ein weiteres Ätzverfahren, mit dem das Material der Grenzflächenschicht auf horizontalen Abschnitten selektiv gegen das auf vertikalen Abschnitten entfernt wird, ist das Ionenstrahlätzen (reactive ion etch, RIE).

Nach einer bevorzugten Ausführungsform des erfindungsgemäßen Verfahrens wird die Grenzflächenschicht auf vertikalen Abschnitten der ersten Struktur durch eine nicht vollständige konforme Abscheidung des Materials der Grenzflächenschicht ausgebildet. Dabei wird ausgenutzt, dass bei der sequentiellen Gasphasenabscheidung die Abscheidung gerichtet von der Substratoberfläche her in die Tiefe einer im Halbleitersubstrat ausgebildeten Struktur hinein erfolgt. Zum mindestens teilweisen Auskleiden des Grabens wird die Grenzflächenschicht durch die sequentielle Gasphasenabscheidung aus einer Mehrzahl von molekularen Einzellagen gebildet, wobei die Abscheidung jeder Einzellage gerichtet von einer Grabenoberkante aus in die Tiefe des Grabens hinein erfolgend gesteuert und die Grenzflächenschicht durch Abbruch der Abscheidung jeder Einzellage vor einer vollständigen Bedeckung vertikal strukturiert abgeschieden wird.

Wird die Abscheidung der Einzellagen jeweils in geeigneter Weise vorzeitig abgebrochen, so wird die Grenzflächenschicht lediglich auf der Substratoberfläche und in oberen Bereichen vertikaler Abschnitte der ersten Struktur, bzw. oberhalb der Kragenoberkante ausgebildet. Auch für ein solches Verfahren ist Aluminiumoxid Al₂O₃ ein geeignetes Material.

Das erfindungsgemäße Verfahren ist weiterhin zum Ausbilden einer Ätzstoppschicht geeignet, wobei die Ätzstoppschicht in gleicher Weise vorgesehen wird wie die Grenzflächenschicht. Die Ätzstoppschicht wird aus einem Material vorgesehen, gegenüber dem Strukturen zwischen der Substratoberfläche und der Ätzstoppschicht ausbildende Materialien mit hoher Selektivität ätzbar sind.

Das erfindungsgemäße Verfahren ist ferner zum Ausbilden einer Ätz- oder Polierstoppsignalschicht geeignet. Nach einem Abtrag von zwischen der Substratoberfläche und der Ätz- oder Polierstoppsignalschicht ausgebildeten Strukturen wird durch freigestellte Abschnitte der Ätzstoppsignalschicht ein Signal generiert oder verändert, das durch eine Ätz- oder Poliervorrichtung auswertbar ist.

Schließlich ist das erfindungsgemäße Verfahren dazu geeignet, eine Grenzflächenschicht als eine Adhäsionsschicht auszubilden, auf der das zweite Material besser haftet als auf dem Material der ersten Struktur.

Die Barriereschicht wird nach der Abscheidung fallweise durch einen Wärme- oder Temperschritt verdichtet.

In besonders vorteilhafter Weise wird die Barriereschicht im Zuge eines mindestens abschnittsweisen Abtrags der Prozessschicht zusätzlich als Ätzstopp- oder Ätzstoppsignalschicht verwendet. Metalloxide weisen eine hohe Ätzselektivität gegenüber siliziumhaltigen Materialien auf. Ist das Metall nicht im abzutragenden Schichtstapel enthalten, so liefert die Barriereschicht bei spektroskopischer Beobachtung ein eindeutiges und leicht identifizierbares Ätzstoppsignal nach Abtrag der aufliegenden Anteile der Prozessschicht.

Das erfindungsgemäße Verfahren führt zu einer Barriereschicht aus Siliziumnitrid oder einem Metalloxid, etwa auch aus einem Oxid seltener Erden, die aus einer sequentiellen Gasphasenabscheidung oder Molekularstrahlepitaxie hervorgegangen ist und als Schichtsystem aus einer Mehrzahl von einmolekularen Einzellagen in einer Schichtdicke ausgebildet ist, bei der ein elektrischer Widerstand der Barriereschicht durch einen auf dem quantenmechanischen Tunneleffekt beruhenden Ladungsträgertransport bestimmt ist.

Bevorzugt beträgt die Schichtdicke weniger als 20 Nanometer, so dass etwa bei Aluminiumoxidschichten noch ein deutlicher Ladungsträgertransport quer zur Schicht gegeben ist. Besonders bevorzugt beträgt die Schichtdicke maximal 5 Nanometer, wobei während eines einstündigen Annealschrittes bei 650 Grad Celsius in einer sauerstoffhaltigen Umgebung eine Oxidbildung in einem der Barriereschicht unterliegenden Grundsubstrat mit Silizium- und Wolframabschnitten zuverlässig verhindert wird. Für Wasserstoffbarriereschichten beträgt die Dicke der Barriereschicht bevorzugt mehr als 5 Nanometer und weniger als 20 Nanometer.

Nachfolgend wird das erfindungsgemäße Verfahren anhand von Figuren näher ausgeführt, wobei für einander entsprechende Schichten und Strukturen gleiche Bezugszeichen verwendet werden. Die Figuren zeigen jeweils schematische Querschnitte von Halbleiterstrukturen. Im einzelnen zeigen:
- Fig. 1: ein erstes Ausführungsbeispiel der erfindungsgemäßen Barriereschicht als Sauerstoffbarriere,
- Fig. 2: ein erstes Ausführungsbeispiel der erfindungsgemäßen Barriereschicht als Metalldiffusionsbarriere für Leiterbahnstrukturen,
- Fig. 3: ein zweites Ausführungsbeispiel der erfindungsgemäßen Barriereschicht als Metalldiffusionsbarriere für Zwischendielektrikums-Kontaktstrukturen,
- Fig. 4: ein drittes Ausführungsbeispiel der erfindungsgemäßen Barriereschicht als Metalldiffusionsbarriere für Gateelektrodenstrukturen,
- Fig. 5: ein Ausführungsbeispiel der erfindungsgemäßen Barriereschicht als Wasserstoffbarriere und
- Fig. 6: ein Ausführungsbeispiel für eine erfindungsgemäße Barriereschicht als Grenzflächenschicht zwischen zwei Halbleiterstrukturen.

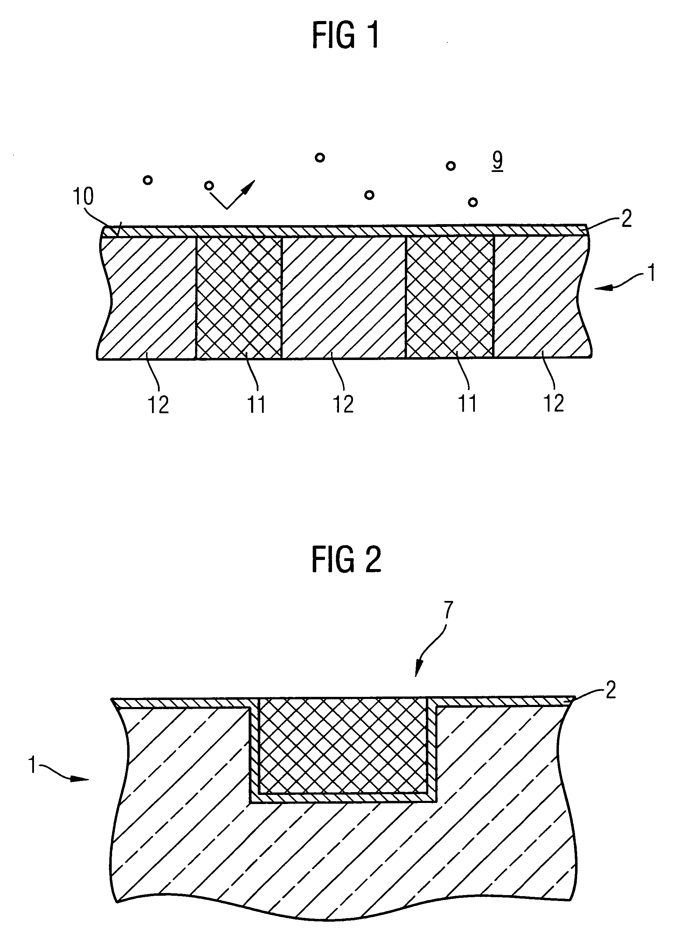

In der Fig. 1 liegt eine Barriereschicht 2 aus mittels sequentieller Gasphasenabscheidung abgeschiedenem Aluminiumoxid auf einer Substratoberfläche 10 eines Grundsubstrats 1 auf, in dem erste 11 und zweite 12 Abschnitte aus unterschiedlichen Materialien ausgebildet sind. Die Abschnitte 11 bestehen etwa aus Wolfram, die Abschnitte 12 etwa aus Silizium. Das Grundsubstrat 1 wird in einem Temperschritt einer Wärmebehandlung in einer Sauerstoffumgebung 9 unterzogen. Bereits bei einer Schichtdicke von 5 Nanometern verhindert die Barriereschicht 2 eine Oxidbildung im Grundsubstrat 1.

Die Fig. 2 zeigt eine in einem isolierenden Grundsubstrat 1, etwa aus Siliziumdioxid, verlaufende Leiterbahnstruktur 7 aus einem Metall. Zwischen dem isolierenden Grundsubstrat 1 und der Leiterbahn 7 ist eine erfindungsgemäß erzeugte Barriereschicht 2 angeordnet, die mittels sequentieller Gasphasenabscheidung auf der durch einen zur Aufnahme der Leiterbahnstruktur 7 vorgesehenen Graben reliefartig strukturierten Substratoberfläche 10 abgeschieden wurde. Die Barriereschicht 2 verhindert ein nachteiliges Ausdiffundieren von Metallatomen aus der Leiterbahnstruktur 7 in das isolierende Grundsubstrat 1. Die Barriereschicht 2 ist zudem als Ätzstopp- oder Ätzstoppsignalschicht im Zuge des Rückätzens von außerhalb des Grabens abgeschiedenen Metall geeignet.

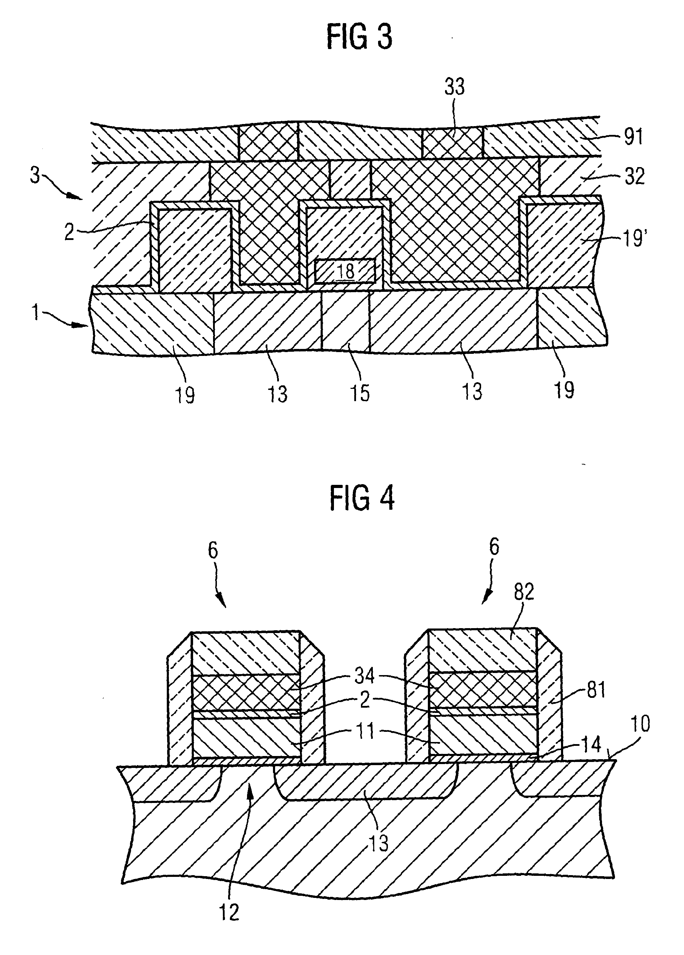

In einem Grundsubstrat 1 gemäß der Fig. 3 sind Isolatorabschnitte 19 und Transistorstrukturen mit Source/Drain-abschnitten 13 und Kanalabschnitten 15 als Bereiche unterschiedlicher Dotierung in einem einkristallinen Halbleitersubstrat sowie in weiteren Isolatorabschnitten 19' eingebettete Gateelektrodenabschnitte 18 ausgebildet. Eine Prozessschicht 3 weist eine Isolatorstruktur 32 durchdringende Kontaktstrukturen 33 zur Verbindung der Source/Drain-Abschnitte 13 mit in vertikaler Richtung über einem Zwischenschichtdielektrikum 91 angeordneten, nicht dargestellten Leiterbahnen auf. Zur Vergrößerung der Oberfläche der Kontaktstrukturen 33 erweitern sich diese über den zweiten Isolatorabschnitten 19' und erstrecken sich über deren Kanten. Eine mittels sequentieller Gasphasenabscheidung abgeschiedene, konforme Barriereschicht 2 bedeckt das Grundsubstrat 1 auch bei geringer Schichtdicke im Bereich der Kanten der Isolatorstrukturen 19' zuverlässig und verhindert ein Ausdiffundieren von Metallatomen aus den Kontaktstrukturen 33 in das Grundsubstrat 1.

Im in der Fig. 4 dargestellten Ausführungsbeispiel wird eine Ausdiffusion von Fremdatomen aus einem hochleitfähigen Abschnitt 34 einer Gateelektrodenstruktur 6 in einen an ein Gatedielektrikum 14 anschließenden Halbleiterabschnitt 11 der Gateelektrodenstruktur 6 durch eine Barriereschicht 2 verhindert. Ferner weist die Gateelektrodenstruktur 6 ein den hochleitfähigen Abschnitt 34 bedeckendes Cap-Nitrid 82 sowie an Seitenwänden Spacerstrukturen 81 aus einem dielektrischen Material auf. Das Grundsubstrat 1 umfasst ferner in monokristallinem Silizium als dotierte Gebiete ausgebildete Source/Drain-Abschnitte 13 und Kanalabschnitte 15.

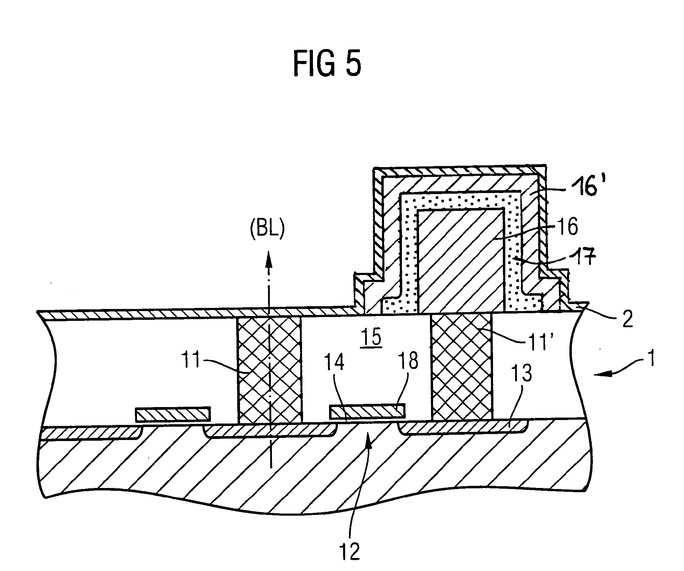

Die Fig. 5 zeigt eine ferroelektrische Speicherzelle mit einem Auswahltransistor und einer in Serie zum Auswahltransistor vorgehenen ferroelektrischen Speichereinrichtung. Der Auswahltransistor besteht aus in monokristallinen Silizium als dotierte Gebiete ausgebildeten Source/Drain-Abschnitten 13 und einem Kanalabschnitt 15 sowie aus einem an den Kanalabschnitt 15 in vertikaler Richtung anschließenden Gatedielektrikumsabschnitt 14 und einem über dem Gatedielektrikumsabschnitt 14 angeordneten Gateelektrodendabschnitt 18.
Über dem Auswahltransistor ist ein Isolatorabschnitt 19' vorgesehen, in dem Kontaktabschnitte 11, 11' zur Kontaktierung der Source/Drain-Abschnitte 13 eingebracht sind. Ein erster Kontaktabschnitt 11 ist zur weiteren Kontaktierung mit einer Bitleitung BL vorgesehen und liegt zunächst frei. Auf einem zweiten Kontaktabschnitt 11' ist ein unterer Elektrodenabschnitt 16 und über diesem ein ferroelektrischer Speicherabschnitt 17 der ferroelektrischen Speichereinrichtung angeordnet. Zwischen dem unteren Elektrodenabschnitt 16 und der zweiten Kontaktstruktur 11' sind mindestes eine Iridiumschicht als Sauerstoff-Barriereschicht und eine Iridiumoxidschicht als Diffusionsbarriere vorgesehen. Das ferroelektrische Speichermaterial, ein Perovskit wie etwa Strontium-Wismut-Tantalat SBT oder Blei-Zirkonium-Titanat PZT wird nach der Abscheidung einem Annealschritt in einer Sauerstoffumgebung zur Rekristallation des Perovskits unterzogen. Auf das ferroelektrische Speichermaterial wird ein oberer Elektrodenabschnitt 16' aufgebracht. Auf die durch die Elektrodenstruktur der Speicherzelle reliefartig strukturierte Substratoberfläche wird eine mehr als 5 und weniger als 20 Nanometer dicke Aluminiumoxidschicht als Barriereschicht 2 vorgesehen, die eine Reduktion des ferroelektrischen Speichermaterials durch eindiffundierenden Wasserstoff während einer Wasserstofftemperung zu einem späteren Zeitpunkt der Prozessierung verhindert.

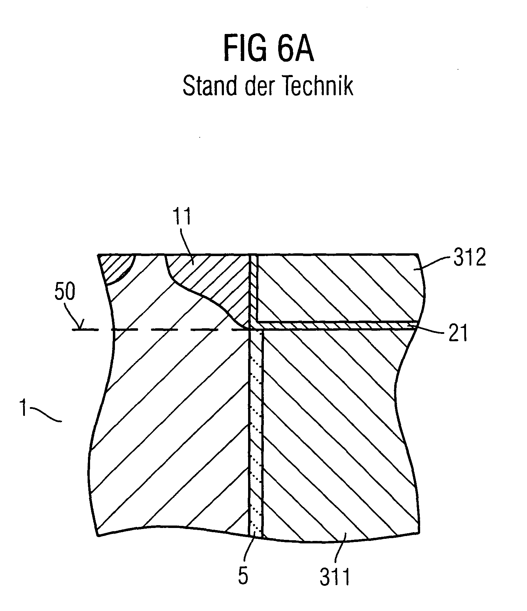

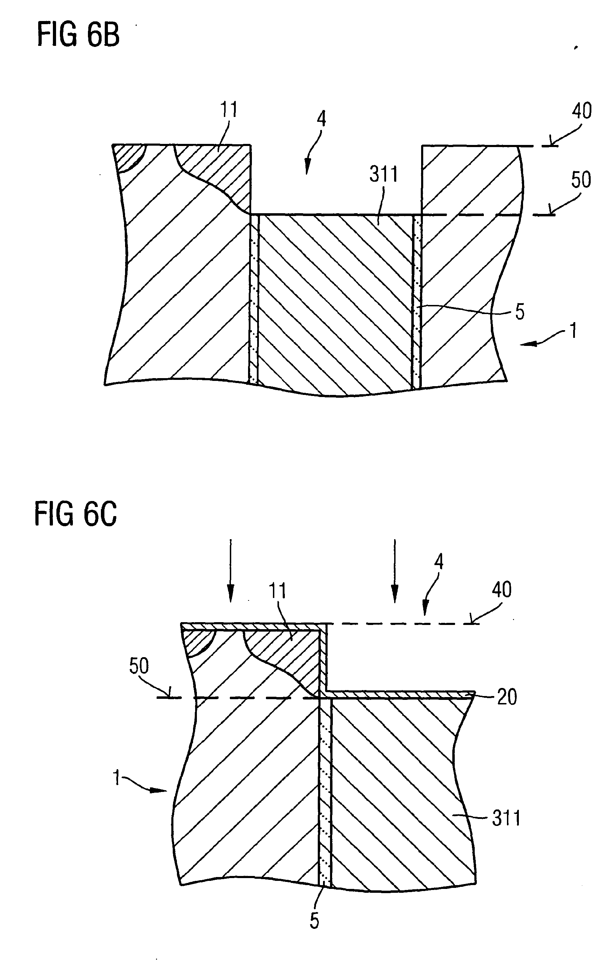

In ein in der Fig. 6B dargestelltes Halbleitersubstrat 1 ist ein Graben 4 eingebracht. Unterhalb einer Kragenoberkante 50 ist der Graben 4 mit einem Kragenisolator 5 ausgekleidet. Im Halbleitersubstrat 1 ist ferner eine erste Struktur 11 mit einkristalliner Kristallisationsstruktur ausgebildet, die oberhalb der Kragenoberkante 50 an den Graben 4 anschließt. Ferner ist der Graben 4 mit einem polykristallinen Material gefüllt, das einen ersten Teilbereich 311 einer im Folgenden herzustellenden zweiten Struktur bzw. Füllstruktur 31 ausbildet.

Es stellt sich im Folgenden die Aufgabe, die elektrisch leitfähige erste Struktur 11, die etwa dem Drainbereich eines Auswahltransistors einer 1T1C-Speicherzelle entspricht und den ersten Teilbereich 311 einer im Inneren des Grabens 4 ausgebildeten ersten Elektrode eines Speicherkondensators der 1T1C-Speicherzelle elektrisch auf einfachste Weise und mit einem Minimum zusätzlicher Prozessschritte elektrisch leitend miteinander zu verbinden.

Bei einem einfachen vollständigen Füllen des Grabens 4 mit dotierten polykristallinen Halbleitermaterial würde oberhalb der Kragenkante 50 ein direkter Übergang zwischen dem polykristallinen Halbleitermaterial der zweiten Struktur 31 und dem einkristallinen Halbleitermaterial der ersten Struktur 11 entstehen. Bei einer weiteren Prozessierung des Halbleitersubstrats 1 bzw. bei einem Betrieb der 1T1C-Speicherzelle würden sich Verwerfungen oder Korngrenzen der Kristallisationsstruktur des polykristallinen Halbleitermaterials zunehmend in das einkristalline Material fortsetzen und dessen Eigenschaften nachteilig verändern. Sind die erste und die zweite Struktur unterschiedlich dotiert, würden in nachfolgenden Prozessschritten Dotieratome in die jeweils andere Struktur diffundieren.

Herkömmlicherweise wird daher, wie in Fig. 6B dargestellt, eine Grenzflächenschicht 21 mittels eines LPCVD-Verfahrens abgeschieden. Danach werden auf einer Oberfläche des Halbleitersubstrats 1 angeordnete Abschnitte der konformen Grenzflächenschicht 21 durch ein CMP-Verfahren (chemical mechanical polishing) entfernt. Ein Entfernen von auf dem ersten Teilbereich 311 angeordneten Abschnitten der Grenzflächenschicht 21 ist nicht ohne Weiteres möglich, so dass die Grenzflächenschicht 21 in diesen Abschnitten belassen wird. Nach dem Abscheiden eines zweiten Teilbereichs 312 der zweiten Struktur vermindert der zwischen den beiden Teilbereichen 311, 312 ausgebildete Abschnitt der Grenzflächenschicht 21 die elektrische und mechanische Qualität der aus den beiden Teilbereichen 311, 312 gebildeten zweiten Struktur 31.

Erfindungsgemäß wird daher eine konforme Vorläuferschicht 20 durch sequentielle Gasphasenabscheidung vorgesehen. Es lässt sich dann eine konforme Hilfsschicht aus einem Material ausbilden, dessen Ätzresistenz in zu einer Oberfläche des Halbleitersubstrats 1 horizontalen Abschnitten gegenüber vertikalen Abschnitten durch Ionenimplantation reduziert werden kann.

Die Richtung der Ionenimplantation ist in der Fig. 6C schematisch durch Pfeile dargestellt. In der Folge sind alle horizontalen Abschnitte der Hilfsschicht bzw. Vorläuferschicht 20 selektiv gegen die vertikalen Abschnitte ätzbar.

Bei der Verwendung anderer Materialien, die in horizontalen Abschnitten der Grenzflächenschicht bevorzugt durch Ionenstrahlätzen (RIE) entfernt werden, geben die Pfeile die Richtung des gerichteten Ätzvorgangs an.

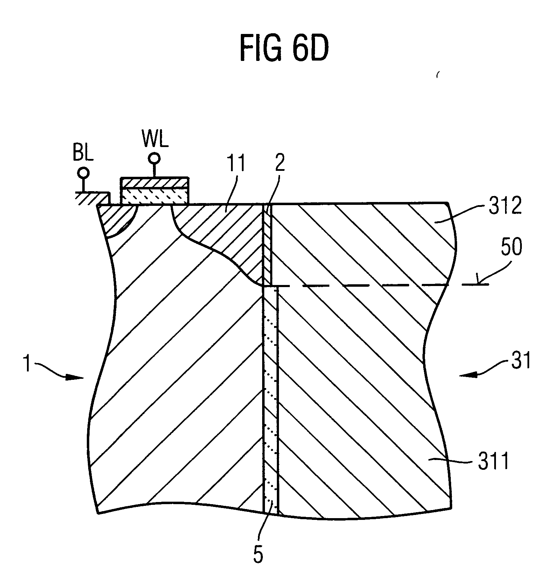

Wie in der Fig. 6D dargestellt, verbleiben nach einem folgenden Ätzschritt lediglich die vertikalen Abschnitte der Vorläuferschicht 20, die die Grenzflächenschicht 2 ausbilden. Die zweite Struktur 31 ist homogen und weist gegenüber einer wie in Fig. 6A dargestellten, aus zwei Teilbereichen 311, 312 beiderseits einer dazwischen angeordneter Grenzflächenschicht 21 zusammengesetzten zweiten Struktur 31, verbesserte elektrische und mechanische Eigenschaften auf. Auf der Oberfläche des Halbleitersubstrats 1 sind die Transistorstrukturen komplettiert und leitfähige Bitleitungsund Wortleitungsstrukturen BL, WL zur Adressierung und Datenübertragung ausgebildet.

### Bezugszeichenliste

- 1: Grundsubstrat
- 10: Substratoberfläche
- 11, 11': erster (Halbleiter-)Abschnitt, Kontaktabschnitt
- 12: zweiter Abschnitt
- 13: Source/Drain-Abschnitt
- 14: Gatedielektrikumsabschnitt
- 15: Kanalabschnitt
- 16: unterer Elektrodenabschnitt
- 16': oberer Elektrodenabschnitt
- 17: Speicherabschnitt
- 18: Gateelektrodenabschnitt
- 19, 19': Isolatorabschnitt
- 2: Barrierenschicht
- 20: Vorläuferschicht
- 21: Grenzflächenschicht
- 3: Prozessschicht
- 31: zweite Struktur
- 311: erster Teilbereich
- 312: zweiter Teilbereich
- 32: Isolatorstruktur
- 33: Kontaktstruktur
- 34: hochleitfähiger Abschnitt
- 4: Graben
- 40: Grabenoberkante
- 5: Kragenisolator
- 50: Kragenoberkante
- 6: Gateelektrodenstruktur
- 7: Leiterbahnstruktur
- 81: Spacer
- 82: Cap-Nitrid
- 9: Umgebung
- 91: Zwischenschichtdielektrikum
- BL: Bitleitung
- WL: Wortleitung

## Patentansprüche

1. Verfahren zur Vermeidung von Verunreinigungen von Schichten und Strukturen in einem Halbleiterwafer durch Fremdstoffe im Zuge einer Fertigung von Halbleitereinrichtungen, bei dem
- ein mindestens abschnittsweise aus einem Primärmaterial ausgebildetes Grundsubstrat (1) bereitgestellt,
- mindestens auf den vom Primärmaterial gebildeten Abschnitten einer Substratoberfläche (10) des Grundsubstrats (1) eine Barriereschicht (2) aus einem für einen oder mehrere Fremdstoffe im Wesentlichen undurchdringlichen Barrierenmaterial vorgesehen und
- das mit der Barriereschicht (2) versehene Substrat (1) einer weiteren Prozessierung unterzogen wird, wobei durch die Barriereschicht (2) ein Austreten/Eindringen des oder der Fremdstoffe aus dem/in das Primärmaterial verhindert wird,
**dadurch gekennzeichnet,**
**dass** die Barriereschicht (2) mittels sequentieller Gasphasenabscheidung oder Molekularstrahlepitaxie als dielektrische Schicht aus Siliziumnitrid oder einem Metalloxid einschließlich einem Oxid seltener Erden vorgesehen wird.

2. Verfahren nach Anspruch 1,
**dadurch gekennzeichnet,**
**dass** die Barriereschicht (2) aus HfO₂, ZrO₂, Ta₂O₅, Nb₂O₅, Al₂O₃, Pr₂O₅ oder La₂O₃ vorgesehen wird.

3. Verfahren nach einem der Ansprüche 1 oder 2,
**dadurch gekennzeichnet,**
**dass** die Barriereschicht (2) in einer einen auf dem quantenmechanischen Tunneleffekt beruhenden Ladungsträgertransport durch die Barriereschicht (2) in mehr als unerheblichen Umfang ermöglichenden Schichtdicke vorgesehen wird.

4. Verfahren nach einem der Ansprüche 1 bis 3,
**dadurch gekennzeichnet,**
**dass** die Barriereschicht (2) in einer Schichtdicke kleiner 20 Nanometer abgeschieden wird.

5. Verfahren nach einem der Ansprüche 1 bis 4,
**dadurch gekennzeichnet,**
**dass** das Grundsubstrat (1) mit einem aus Gräben (4) und Stegen gebildeten Relief an der Substratoberfläche (10) bereitgestellt wird.

6. Verfahren nach einem der Ansprüche 1 bis 5,
**dadurch gekennzeichnet,**
**dass** das mit der Barriereschicht (2) versehene Grundsubstrat (1) einem Annealschritt in sauerstoffhaltiger Umgebung ausgesetzt und durch die Barriereschicht (2) eine Oxidation des Primärmaterials verhindert wird.

7. Verfahren nach einem der Ansprüche 1 bis 5,
**dadurch gekennzeichnet,**
**dass** das mit der Barriereschicht (2) versehene Grundsubstrat (1) einem Annealschritt in wasserstoffhaltiger Umgebung ausgesetzt und durch die Barriereschicht (2) eine Reduktion des Primärmaterials verhindert wird.

8. Verfahren nach einem der Ansprüche 1 bis 5,
**dadurch gekennzeichnet,**
**dass** das mit der Barriereschicht (2) versehene Grundsubstrat (1) einem Wärmeschritt in ammoniakhaltiger Umgebung ausgesetzt und durch die Barriereschicht (2) eine Nitridierung des Primärmaterials verhindert wird.

9. Verfahren nach einem der Ansprüche 1 bis 5,
**dadurch gekennzeichnet,**
**dass** das mit der Barriereschicht (2) versehene Grundsubstrat (1) einem Wärmeschritt in arsinhaltiger Umgebung ausgesetzt und durch die Barriereschicht (2) eine Dotierung des Primärmaterials mit Arsen verhindert wird.

10. Verfahren nach einem der Ansprüche 6 bis 9,
**dadurch gekennzeichnet,**
**dass** die Barriereschicht (2) nach dem Wärme- oder Annealschritt in einem Hochtemperaturschritt aufgebrochen und dadurch die Leitfähigkeit der Barriereschicht (2) erhöht wird.

11. Verfahren nach einem der Ansprüche 1 bis 10,
**dadurch gekennzeichnet,**
**dass** auf der Barriereschicht (2) eine mindestens abschnittsweise aus einem Sekundärmaterial bestehende Prozessschicht (3) vorgesehen wird.

12. Verfahren nach einem der Ansprüche 1 bis 11,
**dadurch gekennzeichnet,**
**dass** als Primärmaterial ein dielektrisches Material und als Sekundärmaterial ein metallhaltiges Material oder als Primärmaterial das metallhaltige Material und als Sekundärmaterial das dielektrische Material vorgesehen werden und durch die Barriereschicht (2) eine Diffusion von Metallatomen und Metallionen aus dem metallhaltigen Material in das dielektrische Material verhindert wird.

13. Verfahren nach einem der Ansprüche 1 bis 11,
**dadurch gekennzeichnet,**
**dass** als Primärmaterial ein Halbleitermaterial und als Sekundärmaterial ein metallhaltiges Material oder als Primärmaterial das metallhaltige Material und als Sekundärmaterial das Halbleitermaterial vorgesehen werden und durch die Barriereschicht (2) eine Diffusion von Metallatomen und Metallionen aus dem metallhaltigen Material in das Halbleitermaterial verhindert wird.

14. Verfahren nach einem der Ansprüche 1 bis 11,
**dadurch gekennzeichnet,**
**dass** jeweils als Primärmaterial und als Sekundärmaterial Halbleitermaterialien mit unterschiedlicher Dotierung vorgesehen werden und durch die Barriereschicht (2) eine Diffusion von Dotierstoffatomen zwischen dem Primär- und dem Sekundärmaterial verhindert wird.

15. Verfahren nach Anspruch 14,
**dadurch gekennzeichnet,**
**dass** als Primärmaterial einkristallines Silizium und als Sekundärmaterial polykristallines Silizium vorgesehen werden.

16. Verfahren nach Anspruch 15,
**dadurch gekennzeichnet, dass**
- in das Grundsubstrat (1) von der Substratoberfläche (10) her ein Graben (4) eingebracht wird,
- im Graben (4) unterhalb einer Kragenoberkante (50) ein Kragenisolator (5) vorgesehen wird,
- eine erste Struktur als ein erster Abschnitt (11) des Grundsubstrats (1) aus dem Primärmaterial mindestens in einem oberhalb der Kragenoberkante (50) an den Graben (4) anschließenden Abschnitt des Grundsubstrats (1) ausgebildet wird,
- ein erster Teilabschnitt (311) einer Füllstruktur (31) aus dem Sekundärmaterial im Graben (4) unterhalb der Kragenoberkante (50) vorgesehen wird,
- der Graben (4) oberhalb der Kragenoberkante (50) mindestens abschnittsweise mir der Barriereschicht (2) ausgekleidet wird und
- ein zweiter Teilabschnitt (312) der Füllstruktur (31) oberhalb der Kragenoberkante (50) angeordnet wird.

17. Verfahren nach Anspruch 16,
**dadurch gekennzeichnet,**
**dass** zum mindestens teilweisen Auskleiden des Grabens (4) die Barriereschicht (2) durch eine sequentielle Gasphasenabscheidung aus einer Mehrzahl von molekularen Einzellagen gebildet wird, wobei die Abscheidung jeder Einzellage gerichtet von einer Grabenoberkante (40) aus in die Tiefe des Grabens (4) erfolgend gesteuert wird und die Barriereschicht (2) durch Abbruch der Abscheidung jeder Einzellage vor einer vollständigen Bedeckung vertikal strukturiert wird.

18. Verfahren nach einem der Ansprüche 1 bis 17,
**dadurch gekennzeichnet,**
**dass** die Barriereschicht (2) im Zuge eines mindestens abschnittsweisen Abtrags der Prozessschicht (3) als Ätzstoppoder Ätzstoppsignalschicht verwendet wird.

19. Barriereschicht aus Siliziumnitrid oder einem Metalloxid zur Verwendung gemäß einem Verfahren nach einem der Ansprüche 1 bis 18,
**dadurch gekennzeichnet,**
**dass** die Barriereschicht (2) mittels einer sequentiellen Gasphasenabscheidung oder Molekularstrahlepitaxie als Schichtsystem aus einer Mehrzahl von einmolekularen Einzellagen in einer Schichtdicke vorgesehen ist, bei der ein elektrischer Widerstand der Barriereschicht (2) durch einen auf dem quantenmechanischen Tunneleffekt beruhenden Ladungsträgertransport bestimmt ist.

20. Barriereschicht nach Anspruch 19,
**gekennzeichnet durch**
eine Schichtdicke von weniger als 20 Nanometern.
